# FASCICULE DE BREVET EUROPEEN

(11) **EP 3 036 565 B1**
(45) Date de publication et mention de la délivrance du brevet: **04.03.2020**
(21) Numéro de dépôt: 14739089.2
(22) Date de dépôt: 02.07.2014
(51) Int. Cl.: G01T 7/00

(54) **MODELISATION 3D TOPOGRAPHIQUE ET RADIOLOGIQUE D'UN ENVIRONNEMENT**
3D-TOPOGRAFISCHE UND RADIOLOGISCHE MODELLIERUNG EINER UMGEBUNG
3D TOPOGRAPHIC AND RADIOLOGICAL MODELING OF AN ENVIRONMENT

(30) Priorité: 23.08.2013 FR 1358153
(43) Date de publication de la demande: 29.06.2016
(73) Titulaire: Orano DS - Démantèlement et Services, 91196 Gif-sur-Yvette (FR)
(72) Inventeur: DUBART, Philippe, 92290 Chatenay Malabry (FR); MORICHI, Massimo, 75010 Paris (FR)
(74) Mandataire: Brevalex
(86) Numéro de dépôt international: PCT/EP2014/064038
(87) Numéro de publication internationale: WO 2015/024694

(56) Documents cités:
- WO-A1-97/01769
- WO-A1-2006/084385
- WO-A1-2008/037988
- US-A1- 2012 043 471
- US-B1- 6 782 123
- US-B1- 8 502 158

## Description

### DOMAINE TECHNIQUE ET ART ANTÉRIEUR

La présente invention concerne un procédé et un dispositif de modélisation d'un environnement contenant de la matière radioactive, et susceptible de présenter un risque de contamination radiologique.

La contamination radiologique ou radioactive est la présence indésirable, à un niveau significatif, de substances radioactives à la surface ou à l'intérieur de structures présentes sur des sites tels qu'une centrale nucléaire de production d'électricité, une installation de traitement de matières nucléaires ou de déchets nucléaires, un laboratoire de recherche.

Par exemple, lorsqu'un accident survient sur un site nucléaire, une équipe de crise dédiée à la gestion de l'accident peut établir un jeu d'hypothèses pour prévoir les conséquences de cet accident avant d'intervenir sur le site et procéder à une éventuelle décontamination.

Le document EP 2 203 854 A0 présente un procédé de gestion d'un accident à évolution temporelle, qui survient à l'intérieur d'une installation à risque et dans lequel on utilise des données géométriques préétablies d'une source de substances nocives que l'on associe à un calcul de quantité de substances nocives pour mettre en œuvre un diagnostic préalable à une intervention.

Un tel procédé nécessite une connaissance préalable de la topographie de l'environnement, et une mise en œuvre de calculs lourds notamment en termes de durée de traitement.

Certains sites peuvent avoir un agencement modulable destiné à évoluer dans le temps, si bien qu'on ne peut pas toujours se fier à des données de topographie d'un site préétablies lorsqu'on intervient sur ce site.

Dans certains cas, par exemple lorsque l'accident survient à la suite d'une catastrophe naturelle et entraine une modification importante de la topographie d'un site, une connaissance préalable d'une cartographie du site peut également s'avérer insuffisante.

Dans le même temps, on cherche à pouvoir se localiser dans un site dans lequel on souhaite intervenir, afin par exemple de procéder à des mesures de contamination nucléaire.

Il se pose le problème de trouver un nouveau procédé de modélisation d'un environnement à risque de contamination nucléaire, amélioré vis-à-vis des problématiques mentionnées ci-dessus.

Le document US 2012/043471 divulgue un système de détermination de la position d'un détecteur de radiation.

Le document WO 2008/037988 divulgue un appareil et un procédé pour la détection et/ou l'imagerie de radiation gamma.

Le document US 8 502 158 divulgue un système distribué pour la détection de radiations, utilisant des détecteurs multiples en clusters.

### EXPOSÉ DE L'INVENTION

Selon un aspect de l'invention, il est prévu, selon la revendication 1, un procédé de modélisation d'un environnement à risque de contamination nucléaire.

Les moyens de détection peuvent être intégrés à un terminal muni d'un écran. La cartographie 3D peut être élaborée en temps réel et être affichée sur l'écran du terminal au fur et à mesure de son élaboration.

Les moyens de traitement informatique sont intégrés au terminal.

A l'aide d'une cartographie 3D telle que mise en œuvre suivant l'invention, on peut planifier les déplacements d'intervenants dans un environnement soumis à des rayonnements ionisants.

Une modélisation de l'environnement dans laquelle des informations topographiques sont associées à des informations radiologiques permet d'identifier des zones dans lesquelles des déplacements d'un opérateur sont déconseillés ou interdits et de distinguer ces zones d'autres régions du site dans lesquelles l'opérateur intervenant sur le site peut évoluer, afin de respecter des normes liées aux doses maximales de rayonnement ionisant auxquelles les intervenants peuvent être soumis.

Le procédé de modélisation peut comprendre en outre des étapes consistant à :
- identifier une ou plusieurs source(s) de substance(s) radioactive(s) dans ledit environnement,
- localiser lesdites sources de substance(s) radioactive(s) sur ladite cartographie établie à l'étape c).

Une cartographie 3D mise en œuvre suivant l'invention peut ainsi renseigner un intervenant sur un site contaminé de la localisation précise des sources de rayonnement ionisant. Elle peut permettre par exemple d'établir un scénario de démantèlement d'un site.

Le procédé de modélisation peut comprendre en outre une étape consistant à estimer un niveau d'activité d'une ou plusieurs sources de substance(s) radioactive(s) identifiées.

La composition en radionucléides desdites sources de substance(s) radioactive(s) peut être également déterminée.

Le procédé de modélisation peut également comprendre en outre une étape consistant à déterminer des caractéristiques géométriques des sources de substance(s) radioactive(s) identifiées.

Le procédé de modélisation peut également comprendre en outre une étape consistant à déterminer des caractéristiques relatives au milieu ou au matériau dans lequel se trouvent lesdites sources de substance(s) radioactive(s) identifiées.

Le procédé peut comprendre en outre une étape consistant à établir une autre cartographie 3D dans laquelle les sources de substance(s) radioactive(s) identifiées et leur activité estimée sont conjointement représentées. Un nouveau calcul en tout point de l'espace des flux émergents (Débit de dose, fluence énergétique) peut être également mis en œuvre.

Selon une possibilité de mise en œuvre du procédé de modélisation, l'acquisition d'informations relatives à la topographie dudit environnement peut comprendre l'acquisition par lesdits moyens de détection d'une ou plusieurs image(s) dudit environnement.

Les données de trajectoire peuvent être alors estimées au moins à partir desdites image(s) dudit environnement.

Le procédé de modélisation peut également comprendre une étape consistant à établir une carte de profondeurs à partir de mesures de distance entre les moyens de détection et un ou plusieurs élément(s) dudit environnement.

Selon un autre aspect de la présente invention, il est prévu également un programme d'ordinateur selon la revendication 7 comprenant des instructions de code de programme pour permettre d'exécuter, hormis l'étape a) d'acquisition, au moins plusieurs des étapes du procédé de modélisation données plus haut.

Selon un autre aspect de la présente invention, il est prévu également un support de données numériques selon la revendication 8 par des moyens de traitement informatiques, comprenant des instructions de code d'un programme d'ordinateur tel que défini plus haut.

Selon un autre aspect, la présente invention prévoit, selon la revendication 9, un dispositif de modélisation d'un environnement à risque(s) de contamination nucléaire.

Les moyens de détection peuvent être intégrés à un terminal. La cartographie 3D peut être élaborée en temps réel et être affichée sur un écran au fur et à mesure de son élaboration, et en particulier sur un écran du terminal.

Les moyens de traitement informatique peuvent être également intégrés au terminal.

En variante, les moyens de traitement informatique sont configurés pour communiquer à distance avec les moyens de détection intégrés au terminal.

Avantageusement, les moyens de traitements informatiques comprennent en outre des moyens pour :
- identifier à partir de ladite matrice, un ou plusieurs ensemble(s) de données décrivant au moins une source de substance(s) radioactive(s) dans ledit environnement,
- localiser ladite source de substance(s) radioactive(s) sur ladite cartographie 3D établie.

Selon une possibilité de mise en œuvre, les moyens de traitements informatiques peuvent comprendre en outre des moyens d'estimation d'un niveau d'activité de ladite source de substance(s) radioactive(s).

Les moyens de traitements informatiques peuvent être en outre configurés pour établir une autre cartographie 3D dans laquelle la source de substance(s) radioactive(s) identifiée, son activité estimée, sont conjointement représentés. Des flux émergents en provenance de la source et qui sont recalculés en tout point de l'espace peuvent être également représentés.

Les moyens de traitements informatiques peuvent également comprendre des moyens d'estimation de la trajectoire des moyens de détection au moins à partir d'image(s) dudit environnement.

Les moyens de traitements informatiques peuvent également comprendre des moyens d'estimation de la trajectoire du dispositif de détection au moins à partir de mesures de position et/ou de déplacement des moyens de détection, et au moins à partir de mesures de distance entre les moyens de détection et un ou plusieurs élément(s) dudit environnement.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 représente un intervenant sur un site nucléaire contaminé, muni d'un dispositif de détection pour collecter des données utiles à la mise en œuvre d'une cartographie 3D dans laquelle la topographie et les données radiologiques du site sont conjointement représentées,
- les figures 2-3 illustrent respectivement, une acquisition simultanée par un intervenant de données topographiques et de données radiologiques d'un site contaminé,
- les figures 4-5 illustrent respectivement une mise en œuvre d'un modèle de données topographiques du site contaminé et d'un modèle de données radiologiques du site contaminé acquises le long de la trajectoire suivie par l'intervenant,
- les figures 6A-6B illustrent une modélisation superposée des données topographiques et des données radiologiques du site contaminé,
- la figure 7 illustre une cartographie dans laquelle des sources à l'origine de rayonnements ionisants ont été localisées,
- la figure 8 illustre une modélisation de termes sources,
- la figure 9 illustre une modélisation dans laquelle des sources identifiées et leur activité associée sont conjointement représentées,
- la figure 10 illustre un exemple d'organigramme de fonctionnement d'un dispositif de modélisation selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

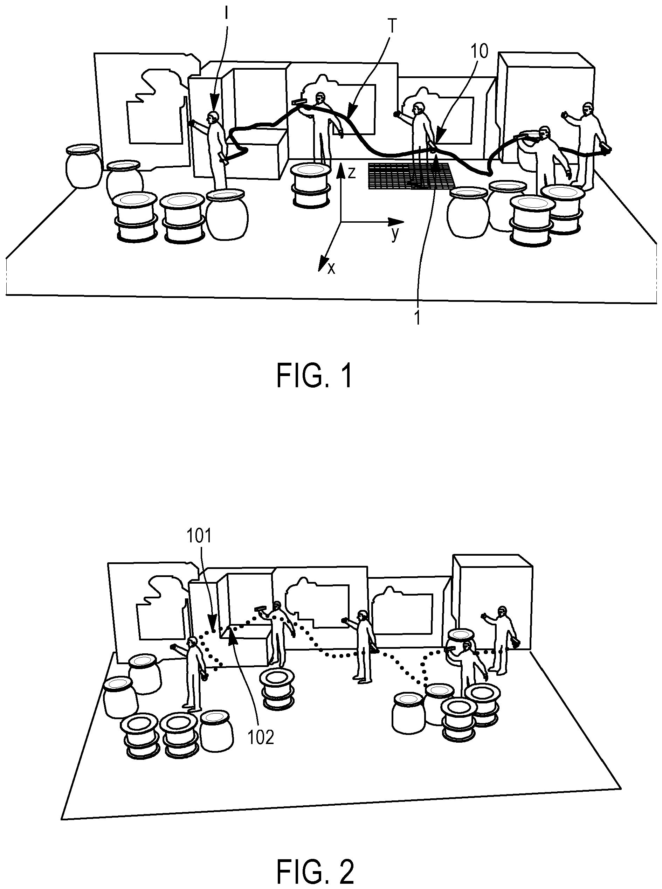

La figure 1 illustre une acquisition de mesures réalisées par un intervenant I, se déplaçant dans un site contaminé dans lequel se trouve de la matière radioactive.

L'intervenant I utilise un dispositif de détection 10 mis en œuvre suivant l'invention, afin d'effectuer une modélisation de ce site, et pouvoir mettre en œuvre une cartographie de ce site, en 3 dimensions, dans laquelle des données topographiques et des données radiologiques sont conjointement représentées, et ce sans nécessairement avoir une connaissance préalable de la topographie du site.

Dans cet exemple, le dispositif de détection 10 peut être intégré à un terminal 1 portable par l'intervenant I, que l'on déplace dans le site contaminé. Pour permettre d'obtenir des mesures sur 3 dimensions, en plus de déplacements classiques sur un même plan (le plan [O,x,y] du repère orthogonal [O,x,y,z] donné sur la figure 1) le dispositif de détection 10 est mû à différentes hauteurs (définies selon l'axe z du repère orthogonal [O,x,y,z]) par rapport au sol du site contaminé.

La cartographie est établie de manière incrémentale au fur et à mesure des déplacements de l'intervenant I, selon une technique de type SLAM (pour « Simultaneous Localization And Mapping » ou cartographie et localisation Simultanée).

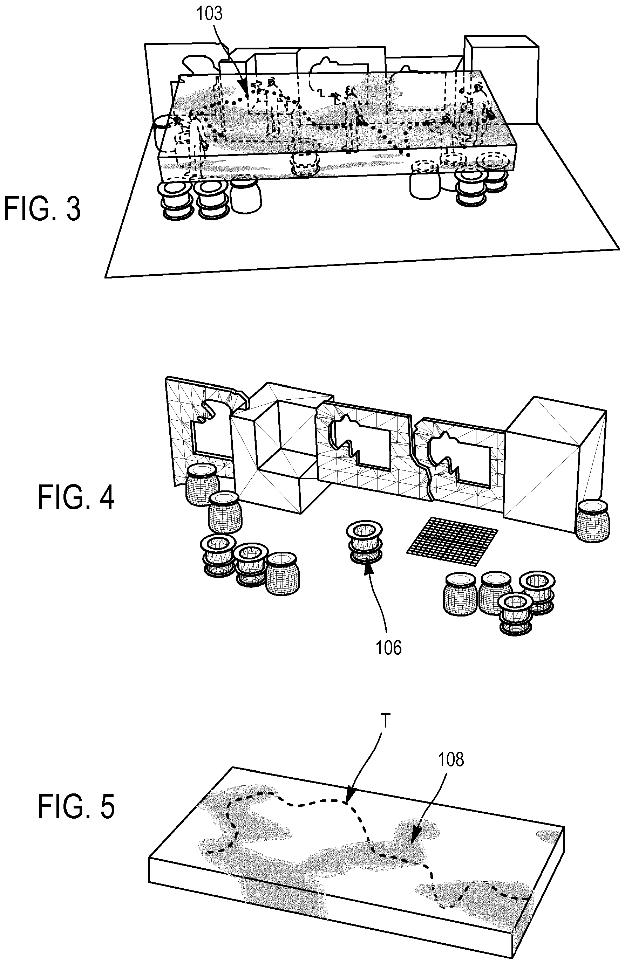

Avec un tel dispositif de détection 10, une acquisition d'informations 101 relatives à la topographie du site et de données odométriques 102 (figure 2) est réalisée simultanément à une acquisition de données de mesures radiologiques 103 (figure 3).

Parmi les informations relatives à la topographie du site acquises au cours du déplacement du dispositif de détection 10, des images des éléments et/ou objets constitutifs du site, des données concernant la forme (volume, surface, distance) et l'apparence, par exemple la texture, d'éléments et/ou objets constitutifs du site, peuvent être enregistrées.

Parmi les données odométriques enregistrées peuvent figurer également des données de distance ou de profondeur entre le dispositif de détection 10 et les éléments et/ou objets constitutifs du site, des données de position et/ou d'orientation du dispositif de détection 10, des données de vitesse de déplacement du dispositif de détection 10 et/ou de variation de vitesse de déplacement.

Ces données odométriques permettent notamment d'évaluer une trajectoire T du dispositif de détection 10 par rapport à un point de départ de déplacement, à partir de laquelle des coordonnées de localisation dans le site du dispositif de détection 10 sont déduites.

Une autre estimation de la trajectoire peut être également réalisée à l'aide desdites images prélevées par le dispositif de détection 10, en utilisant des amers visuels servant de référents et que l'on cherche à retrouver sur chaque image pour en déduire une trajectoire.

Ces différentes estimations de trajectoire peuvent être ensuite comparées et combinées afin de produire une nouvelle estimation de trajectoire.

Simultanément à l'acquisition de données topographiques et de données permettant d'estimer une trajectoire du dispositif de détection 10, les données de mesures radiologiques sont prélevées à l'aide d'un ou plusieurs capteurs intégrés au dispositif de détection 10. Ces mesures radiologiques peuvent comprendre des mesures de taux de comptage en fonction de l'énergie et de débit de dose, par exemple à l'aide d'un radiamètre intégré, ainsi que des mesures par spectrométrie gamma.

La figure 4 illustre une modélisation en 3D de la topographie d'éléments 106 du site contaminé détectés le long de la trajectoire suivie par le dispositif de détection 10 et mise en œuvre à l'aide d'un système de traitement informatique, tandis que la figure 5 illustre une modélisation d'une distribution radiologique 108 le long de ladite trajectoire suivie par le dispositif de détection 10.

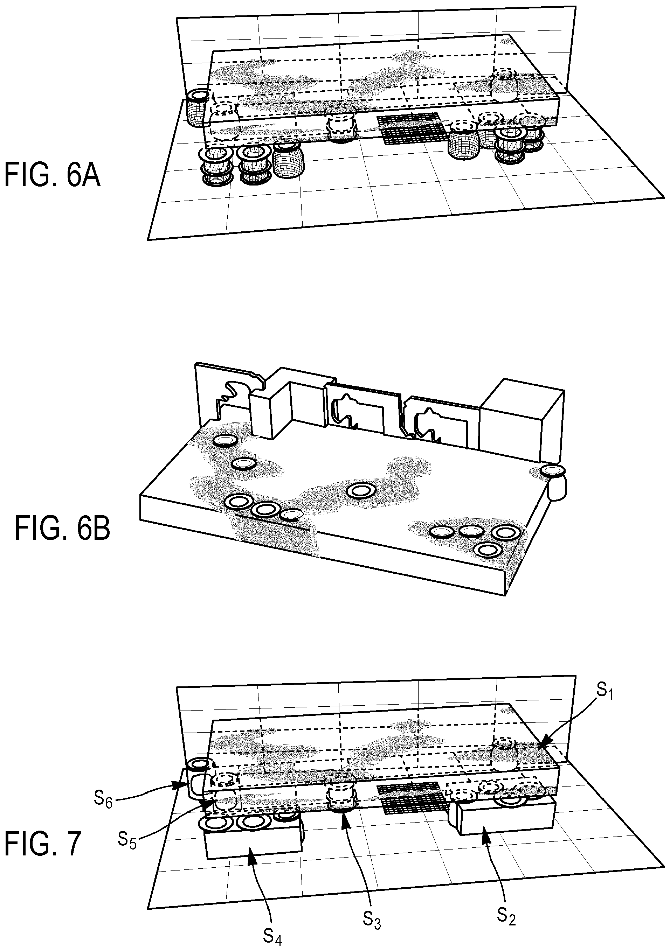

Ces modélisations sont superposées dans une même cartographie 3D (figures 6A et 6B), qui peut être construite de manière incrémentale.

Pour établir cette cartographie, une méthode de prédiction par exemple du type celle décrite dans le document EP 1170 681 dans laquelle une interpolation des données radiologiques est effectuée, peut être mise en œuvre.

Une méthode d'estimation linéaire de type Krigeage par exemple telle que décrite dans le document EP 0 960344 peut être également utilisée pour réaliser l'interpolation des données radiologiques dans le volume délimité par la trajectoire, voire une méthode de pondération Inverse à la Distance (PID).

La cartographie 3D peut être construite en temps réel et peut être ainsi disponible et affichée sur un écran du terminal 1 de l'intervenant I, au fur et à mesure de son élaboration.

La superposition des modèles est effectuée par le biais du système de traitement informatique qui combine les données prélevées par le dispositif de détection 10 dans une matrice et produit de manière incrémentale une cartographie 3D dans laquelle des données topographiques et des données radiologiques sont réunies.

Selon un exemple, un vecteur de mesures effectuées à un instant t et à partir duquel la matrice Pₜ est élaborée, peut avoir la forme suivante : Pₜ = f (M(x,y,z), C(E), D, I(M))ₜ, avec M la position du détecteur par rapport à un repère [0,x,y,z], C(E) un nombre de coups mesuré en fonction de l'énergie, D une mesure de dose, I une image prise à la position M.

Ce système de traitement informatique est intégré audit terminal.

Une étape d'identification de source(s) de substance(s) radioactive(s) dans ledit environnement peut être également réalisée à l'aide de ce système de traitement informatique, la ou les sources identifiée(s) pouvant être ensuite représentée(s) sur une cartographie qui peut être disponible pour l'opérateur sur un écran de son terminal.

La figure 7 illustre une telle cartographie 3D sur laquelle des sources S₁, S₂, S₃, S₄, S₅, S₆ radioactives ont été localisées.

Une détermination de termes sources, c'est-à-dire de termes qui décrivent un ensemble de données des sources S₁, S₂, S₃, S₄, S₅, S₆ identifiées comme étant à l'origine des rayonnements ionisants est également effectué.

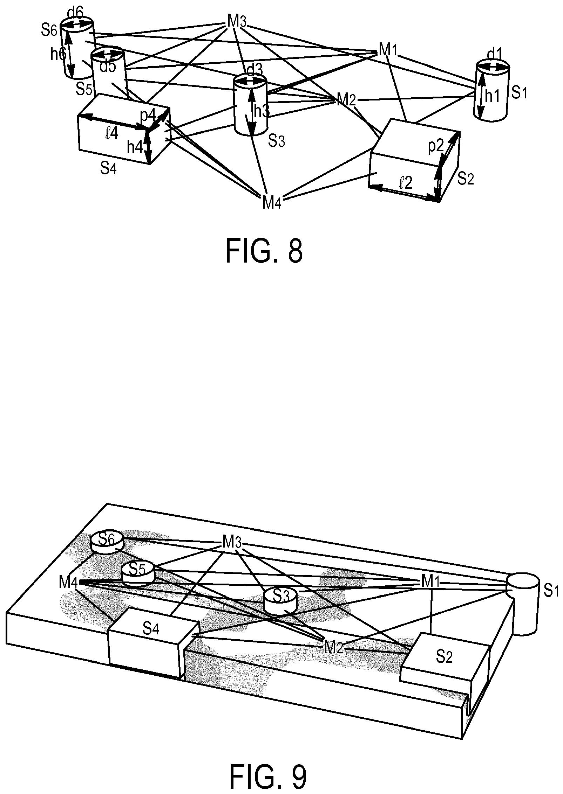

Les termes sources comprennent des données relatives à la géométrie des sources et notamment à leurs dimensions telles que le diamètre dx, la hauteur hx, la profondeur px, la longueur Lx, la largeur Ix, ainsi que des données de distance des sources les unes par rapport aux autres et à des points de mesure M1, M2, M3, M4, M5, M6 par lesquels le dispositif de détection 10 est passé (figure 8).

Ces données peuvent être obtenues par calcul à l'aide d'algorithmes de reconnaissance de forme.

Les termes sources peuvent également comprendre des hypothèses relatives à la composition physico-chimique, le type de milieu ou de matériau dans lequel les sources sont intégrées, la densité apparente de ce milieu ou de ce matériau.

La détermination des termes sources est complétée également par une estimation de l'activité et de la composition en radionucléides de chaque source S₁, S₂, S₃, S₄, S₅, S₆ à l'origine de l'irradiation.

Une estimation de l'activité des sources d'irradiations présentes dans la scène radiologique peut être réalisée à l'aide de méthodes d'estimation probabiliste par exemple de type Monte-Carlo, ou déterministe par exemple de type intégration kernel, en utilisant les données radiologiques collectées par le dispositif de détection 10.

L'estimation de l'activité des sources d'irradiations présente dans la scène radiologique peut également comprendre une étape d'optimisation.

Cette optimisation peut être une optimisation linéaire avec ou sans contraintes, le nombre de sources et de points de mesures étant corrélés. Un tel type d'optimisation linéaire comprend par exemple l'utilisation d'un algorithme de type simplexe.

En variante, une optimisation non-linéaire avec ou sans contraintes, le nombre de sources et de points de mesures n'étant pas corrélés, peut être mise en œuvre. Cet autre type d'optimisation non-linéaire peut être effectué à l'aide de méthodes itératives de type GRG (en anglais « Generalized Reduced Gradient »).

Une nouvelle modélisation dans laquelle l'ensemble des sources S₁, S₂, S₃, S₄, S₅, S₆ identifiées et leurs termes sources associés sont intégrés peut être alors mise en œuvre (figure 9). On peut ainsi établir une nouvelle cartographie 3D des flux émergents recalculés en tout point de l'espace et dans lequel des données radiologiques en particulier des données de contamination radiologique ou d'activité estimées des différentes sources sont représentées.

La collecte de mesures telle qu'illustrée sur la figure 1, peut en variante être effectuée par un drone ou un robot, commandé à distance ou bien se déplaçant de manière autonome à l'aide de données odométriques et des images prélevées par le dispositif de détection 10. Dans ce cas, le drone ou le robot est adapté pour se mouvoir à différentes altitudes ou hauteurs, ce afin de mettre en œuvre une cartographie en 3 dimensions.

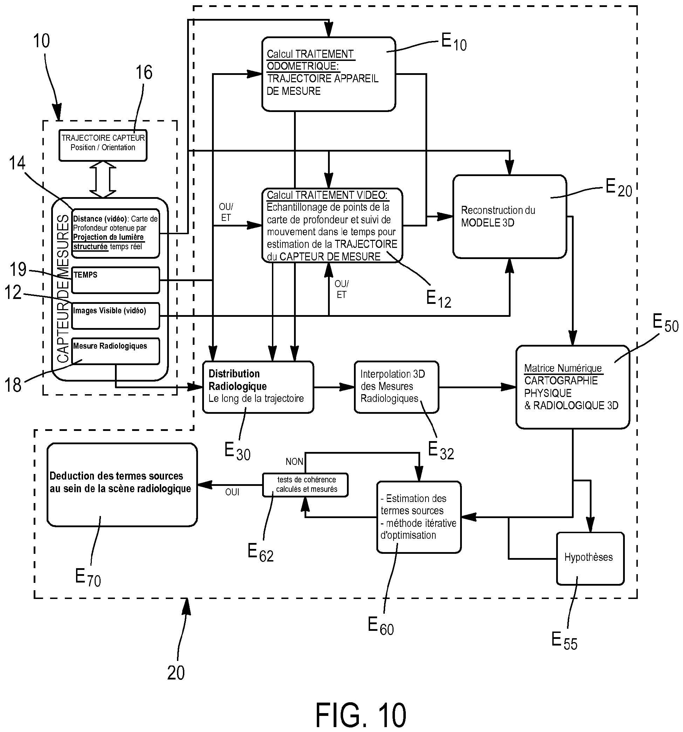

La figure 10 illustre un fonctionnement d'un exemple de dispositif de modélisation d'un environnement à risque de contamination nucléaire.

Ce dispositif comporte tout d'abord un dispositif de détection 10, tel qu'évoqué précédemment, comportant des moyens d'acquisition de données topographiques et de données odométriques.

Le dispositif de détection comporte un système 12 d'acquisition d'images, qui peut comprendre une ou plusieurs caméras par exemple des caméras stéréo et/ou un scanner tridimensionnel intégré pour permettre également de recueillir des informations concernant la forme (volume, surface) et éventuellement l'apparence, par exemple la texture d'éléments ou objets constitutifs d'un environnement. Le scanner peut être, par exemple, un scanner actif sans contact émettant un rayonnement, par exemple laser, dans l'environnement et détectant un rayonnement réfléchi. Le dispositif de détection 10 peut en variante intégrer un système imageur tel que décrit dans le document US 2006/0221072 A1.

Le système imageur peut être également associé ou couplé à un module de mesure de distance 14, afin d'établir une carte de profondeur qui sera combinée aux images acquises par le système imageur 12. Le capteur de mesure de distance peut être par exemple un dispositif télémétrique infra-rouge projetant de la lumière structurée sur les objets ou éléments constitutifs de l'environnement étudié, ou un télémètre à ultrasons.

Le dispositif comprend en outre un module d'acquisition 16 de données odométriques comprenant un ou plusieurs capteur(s) de mouvement, et/ou capteur(s) inertiel(s), par exemple un accéléromètre et/ou un gyromètre, ou un ensemble d'accéléromètres et de gyromètres formant une centrale inertielle.

Ce module d'acquisition 16 peut être également couplé au système imageur 12 et permet notamment d'enregistrer des informations relatives à l'environnement, mais également des données relatives à la trajectoire suivie par le dispositif de détection 10, ces données de trajectoire étant utiles à la construction de la cartographie d'un environnement et à une localisation du dispositif de détection 10 dans cet environnement, par exemple en constituant des coordonnées 3D.

Le dispositif de détection 10 comprend en outre un module 18 d'acquisition de données radiologiques telles que des données de mesure de taux de comptage, de débit de dose, des données de spectrométrie gamma.

Une base de temps 19 est utilisée pour permettre d'effectuer un recalage temporel des différentes données, images, mesures, acquises par le dispositif de détection.

Pour mettre en œuvre la modélisation à partir des données collectées par le dispositif de détection 10, le dispositif de modélisation suivant l'invention comprend en outre un système de traitement 20 informatique dont un exemple d'organigramme de fonctionnement est illustré sur la figure 10.

Une étape de traitement (étape E₁₀) effectuée par le système 20, consiste à utiliser les données fournies par le module d'acquisition 16 de données odométriques et par le module capteur de distance 14 pour réaliser une estimation de trajectoire du dispositif de détection 10.

Une autre estimation (étape E₁₂) de la trajectoire du dispositif de détection 10 utilisant les images fournies par le système imageur 12 et éventuellement des données odométriques provenant des modules 14 et 16 peut être effectuée en parallèle.

Ces estimations peuvent être comparées afin de réaliser une nouvelle estimation de trajectoire.

Le système de traitement est également prévu pour effectuer une reconstruction d'un modèle 3D (étape E₂₀) de l'environnement, dans lequel le dispositif de détection 10 se déplace, à partir d'images et de données odométriques.

Simultanément à cette reconstruction, le système de traitement est configuré pour effectuer une modélisation de la distribution radiologique de l'environnement le long de ladite trajectoire suivie par le dispositif de détection 10 (étape E₃₀).

Le système de traitement est configuré en outre pour mettre en œuvre une interpolation (étape E₃₂) des mesures radiologiques.

Le résultat de cette interpolation et le modèle 3D obtenu à l'issue de l'étape de reconstruction E₂₀ permettent au système 20 de constituer (étape E₅₀) une matrice dans laquelle des données topographiques de l'environnement étudié et lesdites données radiologiques associées à des données de localisation sont réunies.

Dans le même temps, une cartographie 3D représentative dudit environnement dans laquelle lesdites données topographiques et lesdites données radiologique sont simultanément représentées est élaborée.

Une étape d'estimation (étape E₆₀) de termes sources concernant la géométrie des sources de rayonnement ionisant, leur composition, le type de radionucléide émis, l'activité des sources est ensuite mise en œuvre. Cette estimation est effectuée en se servant d'hypothèses déduites (étape E₅₅) à partir des données acquises par mesures éventuellement combinées à des données entrées par un utilisateur du dispositif de modélisation.

Une méthode d'optimisation avec ou sans contrainte peut être également effectuée pour améliorer l'estimation.

On peut réaliser une comparaison (étape E₆₂) pour vérifier une cohérence entre des données radiologiques, par exemple les débits de dose, qui ont été calculées et des données radiologiques mesurées, afin d'affiner cette estimation.

Une étape (Etape E70) consistant à produire une nouvelle modélisation dans laquelle les sources et leurs termes sources associés sont intégrés est ensuite mise en œuvre. Cette nouvelle modélisation peut être représentée sous forme d'une nouvelle cartographie 3D des flux émergents recalculés en tout point de l'espace, dans laquelle les sources et leur activité sont conjointement représentées.

Le système de traitement informatique 20 évoqué plus haut comporte au moins un processeur programmable, un module mémoire et un périphérique d'entrée, couplés à un bus système.

Le processeur peut être, par exemple, un microprocesseur, un FPGA ou un processeur d'unité centrale. Le module mémoire peut comprendre, par exemple une mémoire morte ROM, une mémoire programme EPROM, une mémoire vive dynamique DRAM ou tout autre type de mémoire RAM, un élément de stockage magnétique ou optique, des registres ou autres mémoires volatiles et/ou non volatiles.

Des algorithmes sous forme d'instructions peuvent être stockées dans la mémoire programme, et permettent d'effectuer une modélisation telle que décrite plus haut, afin de produire une cartographie 3D.

Un programme, permettant de mettre en œuvre le procédé de modélisation peut être résidant ou enregistré sur un support (par exemple: une carte mémoire SDRAM ou un disque DVD-ROM ou Blue-ray ou un disque dur amovible ou un support magnétique ou une clé USB) susceptible d'être lu par le système informatique.

Le système de traitement informatique 20 peut être également relié à un périphérique tel que par exemple un écran permettant d'afficher la cartographie 3D sur laquelle des données topographiques d'un environnement et des données radiologiques, en particulier de contamination nucléaire de cet environnement, sont simultanément représentées. Le système de traitement informatique 20 peut être intégré au terminal

Le système informatique peut être relié à un réseau, éventuellement par communication sans fil.

## Revendications

1. Procédé de modélisation d'un environnement à risque de contamination nucléaire comprenant des étapes consistant à :
a) acquérir, à l'aide d'un terminal comprenant des moyens de détection (10) et par déplacement sur 3 dimensions du terminal dans ledit environnement :
- des informations relatives à la topographie dudit environnement et des donnés odométriques respectivement par le biais de moyens d'acquisition de données topographiques intégrés aux moyens de détection (10) et par le biais de moyens d'acquisition de données odométriques intégrés aux moyens de détection (10), et
- des données de mesures radiologiques dudit environnement, puis par le biais de moyens de traitement informatique (20) intégrés audit terminal :
- estimer des données de trajectoire au moins à partir de mesures de position et/ou de déplacement desdits moyens de détection (10), et au moins à partir de mesures de distance entre les moyens de détection et un ou plusieurs élément(s) dudit environnement,
b) associer lesdites données de mesures radiologiques à des données de localisation dans ledit environnement, lesdites données de localisation ayant été déduites à partir de données de trajectoire desdits moyens de détection,
c) établir, à l'aide desdites informations et par le biais desdits moyens de traitement informatique : au moins une matrice dans laquelle des données topographiques dudit environnement et des données radiologiques associées aux données de localisation sont réunies, et une cartographie en 3 dimensions représentative dudit environnement dans laquelle lesdites données topographiques et lesdites données radiologiques sont conjointement représentées,
la cartographie étant élaborée en temps réel et étant affichée sur un écran du terminal au fur et à mesure de son élaboration.

2. Procédé de modélisation selon la revendication 1, comprenant en outre des étapes consistant à :
- identifier, par le biais des moyens de traitement informatique et à partir de ladite matrice, une ou plusieurs sources de substance(s) radioactive(s) dans ledit environnement,
- localiser, par le biais des moyens de traitement informatique, lesdites sources de substance (s) radioactive (s) sur ladite cartographie établie à l'étape c).

3. Procédé de modélisation selon la revendication 2, comprenant en outre une étape consistant à déterminer, un ou plusieurs ensemble(s) de données appelées termes sources caractérisant au moins une source de substance(s) radioactive(s) identifiée, la détermination des termes source comprenant une estimation d'un niveau d'activité de ladite source de substance(s) radioactive(s) identifiée.

4. Procédé de modélisation selon l'une des revendications 2 ou 3, comprenant en outre une étape consistant à établir une autre cartographie 3D de flux émergents recalculés dans laquelle des sources de substance(s) radioactive(s) identifiées et leur activité estimée sont conjointement représentées.

5. Procédé de modélisation selon l'une des revendications 1 à 4, dans lequel l'acquisition d'informations relatives à la topographie dudit environnement comprend l'acquisition par lesdits moyens de détection d'une ou plusieurs image(s) dudit environnement, lesdites données de trajectoire étant estimées au moins à partir desdites image(s) dudit environnement.

6. Procédé de modélisation selon l'une des revendications 1 à 5, comprenant en outre l'établissement d'une carte de profondeurs à partir de mesures de distance entre les moyens de détection et un ou plusieurs élément(s) dudit environnement.

7. Programme d'ordinateur comprenant des instructions de code de programme pour permettre à des moyens de traitements informatiques d'exécuter une ou plusieurs des étapes du procédé suivant l'une quelconque des revendications 1 à 6.

8. Support de données numérique utilisable par des moyens de traitements informatiques, comprenant des instructions de code d'un programme d'ordinateur selon la revendication 7.

9. Dispositif de modélisation d'un environnement à risque(s) de contamination nucléaire comprenant :
- un terminal doté de moyens de détection (10), les moyens de détection comprenant :
• des premiers moyens d'acquisition (12, 14, 16, 19) d'informations relatives à la topographie dudit environnement, **caractérisé en ce qu'**il comprend en outre:
• des deuxièmes moyens d'acquisition (19) adaptés à l'acquisition de mesures radiologiques dudit environnement,
• des moyens d'acquisition de données odométriques intégrés aux moyens de détection (10), comprenant un ou plusieurs capteur(s) de mouvement, et/ou capteur(s) inertiel(s),
- des moyens de traitement informatique (20) reliés à un écran, les moyens de traitement informatique étant intégrés au terminal et
configurés pour :
- estimer des données de trajectoire au moins à partir de mesures de position et/ou de déplacement desdits moyens de détection (10), et au moins à partir de mesures de distance entre les moyens de détection et un ou plusieurs élément(s) dudit environnement,
- associer lesdites mesures radiologiques à des données de localisation dans ledit environnement, lesdites données de localisation ayant été déduites à partir des données de trajectoire desdits moyens de détection (10),
- établir, de manière incrémentale, au moins une matrice dans laquelle des données topographiques dudit environnement et des données de radiologiques associées aux données de localisation sont réunies, et une cartographie 3D représentative dudit environnement dans laquelle lesdites données topographiques et lesdites données radiologiques sont conjointement représentées,
la cartographie 3D étant élaborée en temps réel et étant affichée sur l'écran du terminal au fur et à mesure de son élaboration.

10. Dispositif selon la revendication 9, dans lequel les moyens de traitement (20) comprennent en outre des moyens pour :
- identifier à partir de ladite matrice, un ou plusieurs ensemble(s) de données décrivant au moins une source de substance(s) radioactive(s) dans ledit environnement,
- localiser ladite source de substance(s) radioactive(s) sur ladite cartographie 3D établie.

11. Dispositif de modélisation selon la revendication 10, les moyens de traitement (20) informatique comprenant en outre des moyens d'estimation d'un niveau d'activité de ladite source de substance(s) radioactive(s) identifiée.

12. Dispositif de modélisation selon la revendication 10 ou 11, dans lequel les moyens de traitement informatique (20), sont en outre configurés pour : établir une autre cartographie 3D des flux émergents recalculés dans laquelle des sources de substance(s) radioactive(s) identifiées et leur activité estimée sont conjointement représentées.

13. Dispositif de modélisation selon l'une des revendications 10 à 12, les moyens de traitement (20) comprenant en outre des moyens d'estimation de la trajectoire des moyens de détection (10) :
- au moins à partir d'image(s) dudit environnement et/ou
- au moins à partir de mesures de position et/ou de déplacement des moyens de détection (10), et au moins à partir de mesures de distance entre les moyens de détection et un ou plusieurs élément(s) dudit environnement.

## Patentansprüche

1. Verfahren zum Modellieren einer Umgebung mit einem Risiko einer nuklearen Kontamination, umfassend Schritte bestehend aus:
a) Aufnehmen mithilfe eines Endgeräts, welches Detektionsmittel (10) umfasst, durch Verlagerung in 3 Dimensionen des Endgeräts in der Umgebung von Informationen bezüglich der Topographie der Umgebung und von odometrischen Daten jeweils mittels Aufnahmemitteln von topographischen Daten, welche in den Detektionsmitteln (10) integriert sind, und mittels odometrischen Daten, welche in den Detektionsmitteln (10) integriert sind, sowie radiologischen Messdaten der Umgebung, dann mittels Datenverarbeitungsmitteln (20), welche in dem Endgerät integriert sind,
- Schätzen von Bahnkurvendaten wenigstens ausgehend von Messungen einer Position und/oder einer Verlagerung der Detektionsmittel (10), sowie wenigstens ausgehend von Messungen eines Abstands zwischen den Detektionsmitteln und einem oder mehreren Elementen der Umgebung,
b) Zuordnen der radiologischen Messdaten zu Lokalisierungsdaten in der Umgebung, wobei die Lokalisierungsdaten ausgehend von Bahnkurvendaten der Detektionsmittel abgeleitet werden,
c) Aufstellen mithilfe der Informationen und mittels der Datenverarbeitungsmittel wenigstens einer Matrix, in welcher die topographischen Daten der Umgebung und radiologische Daten, welche den Lokalisierungsdaten zugeordnet sind, vereinigt sind, und einer Kartografie in 3 Dimensionen, welche die Umgebung repräsentiert, in welcher die topographischen Daten und die radiologischen Daten gemeinsam repräsentiert sind,
wobei die Kartographie in Echtzeit erstellt wird und auf einem Bildschirm des Endgeräts nach und nach während ihrer Erstellung angezeigt wird.

2. Verfahren zum Modellieren nach Anspruch 1, ferner umfassend Schritte bestehend aus:
- Identifizieren mittels Datenverarbeitungsmitteln und ausgehend von der Matrix von einer oder mehreren Quellen einer oder mehrerer radioaktiver Substanzen in der Umgebung,
- Lokalisieren mittels Datenverarbeitungsmitteln der Quellen der radioaktiven Substanz(en) in der in Schritt c) aufgestellten Kartographie.

3. Verfahren zum Modellieren nach Anspruch 2, ferner umfassend einen Schritt bestehend aus einem Bestimmen von einer oder mehreren Menge(n) von Daten, welche als Quellenausdrücke bezeichnet werden, welche wenigstens eine identifizierte Quelle einer oder mehrerer radioaktiver Substanzen kennzeichnen, wobei die Bestimmung der Quellenausdrücke ein Schätzen eines Aktivitätsniveaus der identifizierten Quelle der radioaktiven Substanz(en) umfasst.

4. Verfahren zum Modellieren nach einem der Ansprüche 2 oder 3, ferner umfassend einen Schritt bestehend aus einem Erstellen einer weiteren 3D-Kartographie von neu berechneten austretenden Flüssen, in welcher die identifizierter Quellen einer oder mehrerer radioaktiver Substanzen und ihre geschätzte Aktivität gemeinsam repräsentiert werden.

5. Verfahren zum Modellieren nach einem der Ansprüche 1 bis 4, wobei die Aufnahme von Informationen bezüglich der Topographie der Umgebung das Aufnehmen von einem oder mehreren Bildern der Umgebung durch die Detektionsmittel umfasst, wobei die Bahnkurvendaten wenigstens ausgehend von diesem/diesen Bild(ern) der Umgebung geschätzt werden.

6. Verfahren zum Modellieren nach einem der Ansprüche 1 bis 5, ferner umfassend das Erstellen einer Tiefenkarte ausgehend von Abstandsmessungen zwischen den Detektionsmitteln und einem oder mehreren Elementen der Umgebung.

7. Computerprogramm, umfassend Programmcode-Anweisungen, um es Datenverarbeitungsmitteln zu erlauben, einen oder mehrere der Schritte des Verfahrens nach einem der Ansprüche 1 bis 6 auszuführen.

8. Digitaler Datenträger, welcher von Datenverarbeitungsmitteln verwendbar ist, umfassend Computerprogrammcode-Anweisungen nach Anspruch 8.

9. Vorrichtung zum Modellieren eines oder mehrerer Risiken einer nuklearen Kontamination, umfassend:
- ein Endgerät, welches mit Detektionsmitteln (10) versehen ist, wobei die Detektionsmittel umfassen:
∘ erste Aufnahmemittel (12, 14, 16, 19) für Informationen bezüglich der Topographie der Umgebung,
∘ zweite Aufnahmemittel (19), welche für das Aufnehmen von radiologischen Messungen der Umgebung eingerichtet sind,
**dadurch gekennzeichnet, dass** sie ferner umfasst:
∘ Mittel zum Aufnehmen von odometrischen Daten, welche in den Detektionsmitteln (10) integriert sind, umfassend einen oder mehrere Bewegungssensoren und/oder Trägheitssensoren,
- Datenverarbeitungsmittel (20), welche mit einem Bildschirm gekoppelt sind, wobei die Datenverarbeitungsmittel in dem Endgerät integriert sind und dazu eingerichtet sind:
- Bahnkurvendaten wenigstens ausgehend von Messungen einer Position und/oder einer Verlagerung der Detektionsmittel (10) und wenigstens ausgehend von Messungen eines Abstands zwischen den Detektionsmitteln und einem oder mehreren Elementen der Umgebung zu schätzen,
- die radiologischen Messungen zu den Lokalisationsdaten in der Umgebung zuzuordnen, wobei die Lokalisationsdaten ausgehend von den Bahnkurvendaten der Detektionsmittel (10) abgeleitet worden sind,
- in inkrementeller Weise wenigstens eine Matrix, in welcher die topographischen Daten der Umgebung und radiologische Daten, welche den Lokalisierungsdaten zugeordnet sind, vereinigt sind, und eine Kartografie in 3 Dimensionen zu erstellen, welche die Umgebung repräsentiert, in welcher die topographischen Daten und die radiologischen Daten gemeinsam repräsentiert sind,
wobei die 3D-Kartographie in Echtzeit erstellt wird und auf einem Bildschirm des Endgeräts nach und nach während ihrer Erstellung angezeigt wird.

10. Vorrichtung nach Anspruch 9, wobei die Verarbeitungsmittel (20) ferner Mittel umfassen zum:
- Identifizieren ausgehend von der Matrix von einer oder mehreren Datenmengen, welche wenigstens eine Quelle einer oder mehrerer radioaktiver Substanzen in der Umgebung beschreiben,
- Lokalisieren der Quelle der radioaktiven Substanz(en) in der erstellten 3D-Kartographie.

11. Vorrichtung zum Modellieren nach Anspruch 10, wobei die Datenverarbeitungsmittel (20) ferner Mittel zum Schätzen eines Aktivitätsniveaus der identifizierten Quelle einer oder mehrerer radioaktiver Substanzen umfassen.

12. Vorrichtung zum Modellieren nach Anspruch 10 oder 11, wobei die Datenverarbeitungsmittel (20) ferner dazu eingerichtet sind zu:
einem Erstellen einer weiteren 3D-Kartographie von neu berechneten austretenden Flüssen, in welcher die identifizierten Quellen einer oder mehrerer radioaktiver Substanzen und ihre geschätzte Aktivität gemeinsam repräsentiert sind.

13. Vorrichtung zum Modellieren nach einem der Ansprüche 10 bis 12, wobei die Verarbeitungsmittel (20) ferner Mittel zum Schätzen der Bahnkurve der Detektionsmittel (10) umfassen:
- wenigstens ausgehend von einem oder mehreren Bildern der Umgebung und/oder
- wenigstens ausgehend von Messungen einer Position und/oder einer Verlagerung der Detektionsmittel (10), und wenigstens ausgehend von Abstandsmessungen zwischen den Detektionsmitteln und einem oder mehreren Elementen der Umgebung.

## Claims

1. A method for modeling an environment with a risk of nuclear contamination comprising steps of:
a) acquiring, using a terminal comprising detection means (10) and through a 3-dimensional displacement of the terminal in said environment:
- information related to the topography of said environment and odometry data respectively by topography data acquisition means integrated into said detection means (10) and by odometry data acquisition means integrated into said detection means (10) and,
- radiological measurement data of said environment, and then via computer processing means (20) integrated into said terminal:
- estimating path data at least from position and/or displacement measurements of said detection means, and at least from distance measurements between the detection means and one or more element(s) of said environment,
b) associating said radiological measurement data with location data in said environment, said location data having been deduced from path data of said detection means,
c) creating, using said information and via said computer processing means: at least one matrix in which topographic data of said environment and radiological data associated with the location data are compiled, and a 3-dimensional mapping representing said environment in which said topographic data and said radiological data are jointly represented,
the mapping being developed in real time and being displayed on a screen of the terminal as it is developed.

2. The modeling method according to claim 1, further comprising steps of:
- identifying, via computer processing means and from said matrix, one or more sources of radioactive substance(s) in said environment,
- locating, via computer processing means, said sources of radioactive substance(s) on said mapping created in step c).

3. The modeling method according to claim 2, further comprising a step of determining one or more set(s) of data referred to as source terms characterizing at least one identified source of radioactive substance(s), determining the source terms comprising estimating an activity level of said identified source of radioactive substance(s).

4. The modeling method according to one of claims 2 or 3, further comprising a step of creating another 3D mapping of recomputed emergent flux in which identified sources of radioactive substance(s) and their estimated activity are jointly represented.

5. The modeling method according to one of claims 1 to 4, wherein acquiring information related to the topography of said environment comprises acquiring by said detection means one or more image(s) of said environment, said path data being estimated at least from said image(s) of said environment.

6. The modeling method according to one of claims 1 to 5, further comprising the creation of a depth map from distance measurements between the detection means and one or more element(s) of said environment.

7. A computer program comprising program code instructions for enabling computer processing means to execute one or more of the steps of the method according to any of claims 1 to 6.

8. A digital data medium usable by computer processing means, comprising code instructions of a computer program according to claim 7.

9. A device for modeling an environment with a risk or risks of nuclear contamination comprising:
- a terminal provided with detection means (10), the detection means comprising :
- first means for acquiring (12, 14, 16, 19) information related to the topography of said environment,
- second acquiring means (19) suitable for acquiring radiological measurements of said environment, **characterized in that** it further comprises:
- odometry data acquiring means (19) integrated into said detection means (10) comprising one or more motion sensors and/or inertial sensors,
- computer processing means (20) connected to a screen, the computer processing means being configured to:
- estimating path data at least from position and/or displacement of said detection means (10), and at least from distance measurements between the detection means and one or more element(s) of said environment,
- associate said radiological measurements with location data in said environment, said location data having been deduced from path data of said detection means (10),
- incrementally create at least one matrix in which topographic data of said environment and radiological data associated with the location data are combined, and a 3D mapping representing said environment in which said topographic data and said radiological data are jointly represented,
the 3D mapping being developed in real time and being displayed on the terminal screen as it is developed.

10. The device according to claim 9, wherein the processing means (20) further comprise means for:
- identifying, from said matrix, one or more set(s) of data describing at least one source of radioactive substance(s) in said environment,
- locating said source of radioactive substance(s) on said created 3D mapping.

11. The modeling device according to claim 10, the computer processing means (20) further comprising means for estimating an activity level of said identified source of radioactive substance(s).

12. The modeling device according to claim 10 or 11, wherein the computer processing means (20) are further configured to: create another 3D mapping of the recomputed emergent flux in which identified sources of radioactive substance(s) and their estimated activity are jointly represented.

13. The modeling device according to one of claims 10 to 12, the processing means (20) further comprising means for estimating the path of the detection means (10):
- at least from image(s) of said environment and/or
- at least from position and/or displacement measurements of the detection means (10), and at least from distance measurements between the detection means and one or more element(s) of said environment.
